# EUROPEAN PATENT APPLICATION

(11) **EP 4 827 304 A1**
(43) Date of publication of application: **21.10.2026**
(21) Application number: 26162415.9
(22) Date of filing: 04.03.2026
(51) Int. Cl.: H10P 50/24, H10P 14/60

(54) **A METHOD OF PLASMA ETCHING**

(30) Priority: 15.04.2025 GB 202505627
(71) Applicant: SPTS Technologies Limited, NP18 2TA (GB)
(72) Inventor: CROOT, Alex, Newport, NP18 2TA (GB); BURMAN, Tristan, Newport, NP18 2TA (GB)
(74) Representative: Wynne-Jones IP Limited

(57) **Abstract**

There is provided a method of plasma etching a silicon carbide substrate to form a feature. The method comprises the steps of: providing a silicon carbide substrate with a mask formed thereon, the mask having an opening; performing a first plasma etch step; performing a second plasma etch step; wherein, the second plasma etch step uses an etch recipe comprising a silicon-containing gas and a nitrogen or nitrogen-containing gas.

## Description

### Field

The present invention relates to a method of plasma etching a feature in a silicon carbide substrate. The present invention also relates to a plasma etching apparatus for plasma etching a silicon carbide substrate to form a feature using the aforementioned method.

### Background

Trench MOSFETs are increasingly required in the production of silicon carbide power devices. The trench most commonly forms the gate when lined with silicon dioxide and filled with polycrystalline silicon. To increase operating voltages, steps must be taken to avoid excessive electric fields from crowding or bunching at the gate bottom corners, which can include shielding by implantation, and/or by increasing the radius of curvature of the corner to reduce field crowding. The latter of these methods is the subject explored herein.

Trenches are formed by plasma etching, with most etch tools capable of producing a trench with either a micro-trenched or a flat base. Some manufacturers will then anneal the material at high temperatures to round the corners, which can be beneficial, but is costly and, importantly, provides equal radius of curvature to the corners at the top of the trench to that of the base corners. Whilst some rounding of the top corners can be beneficial, it is often desirable to have a larger radius at the base compared to the top.

For this reason, some methods have been devised to round the base corners upon plasma etching the trench feature. This morphology of trench can then be annealed for less time, at a lower temperature (reducing costs), or simply not annealed at all if the trench meets the required characteristics.

US2021/0175082A1 describes a method of *in-situ* etching a silicon carbide trench with rounded base corners. The method includes a first anisotropic etch which is fast and low-deposition, i.e. a traditional trench etch, followed by a second anisotropic etch which is high-deposition. During the second etch, a passivation material is deposited onto the trench sidewalls and mask to attenuate the etching at the peripheral regions of the trench, thereby rounding the corners of the trench base.

In the above method of the prior art, the second step uses a combination of silicon-containing gas and oxygen to produce a passivation layer comprising silicon oxide, which is chemically similar to the silicon dioxide mask material. This chemical compatibility ensures good selectivity of the etch of the passivation layer to the silicon carbide, so provides a rational starting point as a chemistry for this process step. It would however be desirable to have alternative passivation layers which could enable rounding at the base of a trench in a SiC wafer but were chemically different to the mask layer to facilitate the removal of the passivation material post SiC trench etch.

### Summary

In a first aspect of the invention there is provided a method of plasma etching a silicon carbide substrate to form a feature. The method comprises the steps of: providing a silicon carbide substrate with a mask formed thereon, the mask having an opening; performing a first plasma etch step to anisotropically etch the substrate through the opening to produce a partially formed feature having a bottom surface comprising a peripheral region; performing a second plasma etch step to anisotropically etch the bottom surface of the partially formed feature through the opening while depositing a passivation material onto the mask so as to reduce a dimension of the opening, wherein the reduction of the dimension of the opening causes an attenuation in the etch of the peripheral region thereby producing a fully formed feature having a bottom surface comprising a central region and an edge region, wherein the central region is deeper than the edge region; wherein, the second plasma etch step uses an etch recipe comprising a silicon-containing gas and a nitrogen or nitrogen-containing gas.

Use of the combination of a silicon containing gas and nitrogen to produce passivation during silicon carbide plasma etching, helps in the formation of rounded base trenches, whilst increasing the ease of removing the passivation layer from the chamber compared with conventional chemistries. It also increases throughput due to benefits in reduced inter-wafer clean time, wherein the cleaning is required to remove material deposited within the chamber.

Each of the silicon-containing gas and the nitrogen or nitrogen-containing gas may be supplied at a flow rate to a plasma chamber containing the silicon carbide substrate, wherein during the second plasma etch step the flow rate of the silicon-containing gas increases and the flow rate of the nitrogen or nitrogen-containing gas increases.

The silicon carbide substrate may be supported on a platen within a plasma chamber, and during the second plasma etch step a source power provided to the plasma chamber may reduce, and a bias power provided to the platen may reduce.

The source power provided to the plasma chamber may reduce between 2500-800 W, for example between 1600-1400 W.

The bias power provided to the platen may reduce between 1500-100W, for example between 1400-400 W. The high RF bias at the beginning helps control net deposition rate while maintaining etching of the SiC.

During the second plasma etch step, the flow rate of the nitrogen or nitrogen-containing gas may increase between 3-40 sccm. The low flows are required to achieve relatively low deposition rates.

During the second plasma etch step, the flow rate of the silicon-containing gas may increase between 80-160 sccm. The low flows are required to achieve relatively low deposition rates.

The silicon-containing gas may be selected from SiCl₄, SiF₄ and SiF₆.

The silicon-containing gas may be SiCl₄.

The second plasma etch step may be conducted at a process pressure between 2-60 mTorr, for example between 6-10 mTorr.

The silicon carbide substrate may be supported on a platen within a plasma chamber and wherein during both plasma etch steps, the platen may be maintained at a temperature of approximately 20 degrees Celsius.

In a second aspect of the invention, there is provided a method of cleaning a plasma chamber comprising performing a method of plasma etching according to the first aspect of the invention, and subsequently cleaning the chamber using a fluorine-based plasma.

In a third aspect of the invention, there is provided a plasma etch apparatus for plasma etching a silicon carbide substrate to form a feature using the method according to any preceding claim. The apparatus comprises: a chamber; a substrate support disposed within the chamber for supporting a substrate thereon; at least one gas inlet for introducing a gas or gas mixture into the chamber at a flow rate; a plasma generating means for sustaining a plasma in the chamber; a power supply for supplying a bias power to the substrate support; a controller configured to switch from a first set of processing conditions to a second set of processing conditions, wherein the first set of processing conditions cause the plasma etch apparatus to perform a first plasma etch step to anisotropically etch the substrate through the opening to produce a partially formed feature having a bottom surface comprising a peripheral region, and wherein the second set of processing conditions cause the plasma etch apparatus to perform a second plasma etch step to anisotropically etch the bottom surface of the partially formed feature through the opening while depositing a passivation material onto the mask so as to reduce a dimension of the opening, wherein the reduction of the dimension of the opening causes an attenuation in the etch of the peripheral region thereby producing a fully formed feature having a bottom surface comprising a central region and an edge region, wherein the central region is deeper than the edge region; and wherein, the second plasma etch step uses an etch recipe comprising a silicon-containing gas and a nitrogen or nitrogen-containing gas.

### Drawings

An embodiment of the invention will now be described by way of example only, with reference to the following schematic drawings:
Figure 1a is a cross-sectional view of a trench in a substrate having a micro-trenched base (prior art);
Figure 1b is a cross-sectional view of a trench in a substrate having a flat base (prior art);
Figure 1c is a cross-sectional view of a trench in a substrate having rounded base corners according to the example embodiment of the invention;
Figure 2 is a schematic illustration of a plasma etch apparatus according to the example embodiment of the invention;
Figure 3 is a schematic illustration of a substate at various stages of etching in accordance with the example embodiment of the invention;
Figure 4a is a scanning electron microscope cross-sectional image of trenches formed according to a method of the prior art;
Figure 4b is a scanning electron microscope cross-sectional image of trenches formed according to a method in accordance with the example embodiment of the invention;
Figure 5 is a scanning electron microscope cross-sectional image of trenches formed according to a method in accordance with the example embodiment of the invention optimised for smoothness.

### Detailed Description

Embodiments of the invention will now be described with reference to the figures.

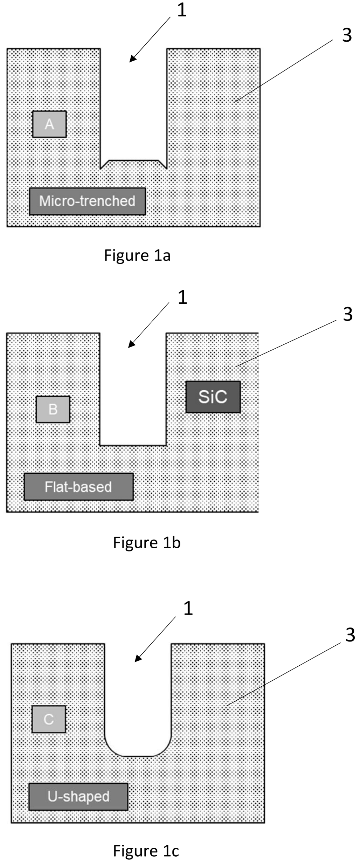

Trenches 1 in a silicon carbide substrate 3 formed by plasma etching tend to have a micro-trenched (Figure 1a) or a flat (Figure 1b) base. A rounded base (Figure 1c) is desirable to avoid excessive electric fields from crowding or bunching at the trench bottom corners. In accordance with embodiments of the invention, the apparatus and method described herein utilise plasma etching to round the corners of a microtrenched or flat base in a silicon carbide substrate 1.

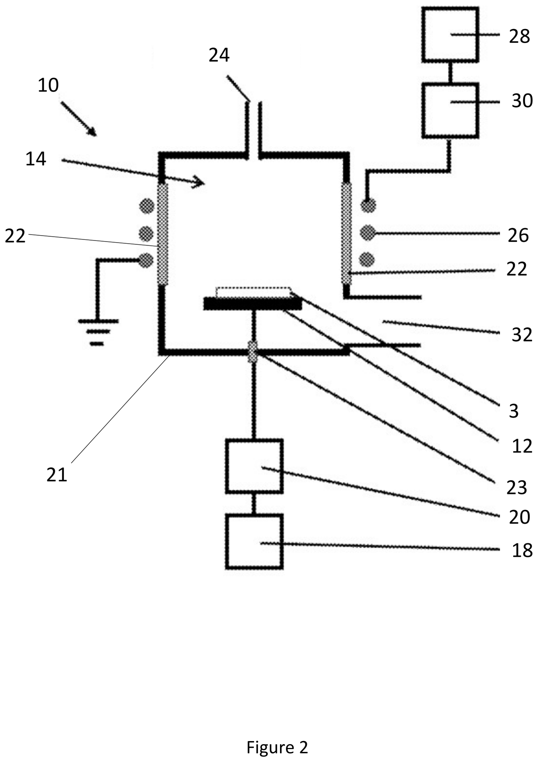

Figure 2 shows a schematic representation of a plasma etch apparatus 10 suitable for performing methods according to embodiments of the present invention. In the example embodiment of the invention, the plasma etch apparatus is an inductively coupled plasma (ICP) system available from SPTS Technologies Limited of Newport, UK. Plasma etching of a substrate is typically performed using a plasma etch apparatus. The plasma etch apparatus can be an (ICP) apparatus. However, etching can also be performed using other dry etch systems, such as helicon, RIE or microwave type apparatus. The operation of generating a plasma within such plasma etch apparatus is well-known in the art and will not be described herein other than where necessary for an understanding of the present invention.

The plasma etch apparatus 10 comprises a substrate support (or platen) 12 disposed within a chamber 14 for supporting a substrate 3. A bias power can be supplied to the substrate support by a RF bias power supply 18 via an impedance matching network 20. The substrate support is isolated from the grounded chamber by a ceramic break 23. The chamber comprises a chamber wall 21 comprising aluminium and having a dielectric part 22. The electromagnetic waves from the ICP antenna would couple with a metallic wall so a dielectric break 22 in the chamber wall 21 is used to minimise losses. Process gases are introduced into the chamber via one or more gas inlets 24. A plasma generating means 26, such as an inductive coil, is used to generate and sustain a plasma within the chamber 14 as is known in the art (e.g. using a source RF power supply 28 and source impedance matching network 30). The gases can be removed from the chamber 14 via a pumping port 32.

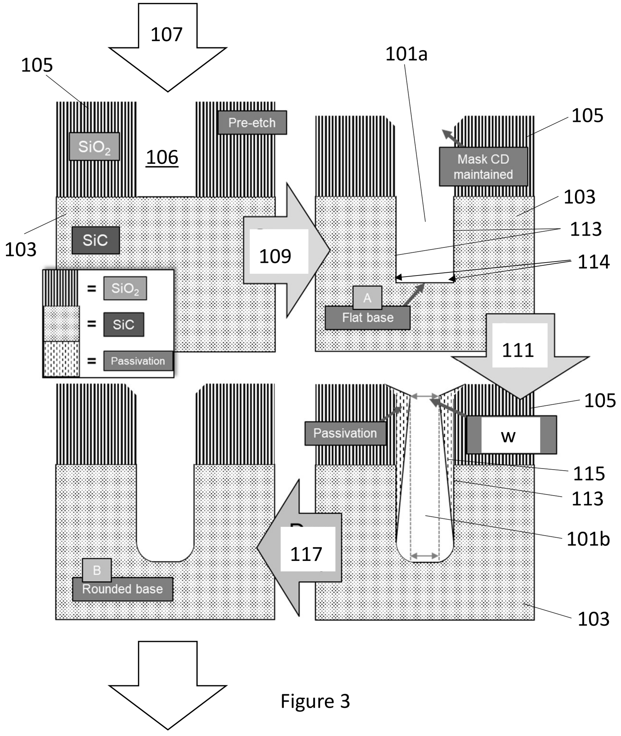

Figure 3 shows the stages of an exemplary method according to an example embodiment of the invention.

In a first step 107 of the method, a silicon carbide substrate 103 is provided having a patterned mask layer 105 thereon. In the example embodiment, the mask comprises silicon dioxide (SiO₂) but in a different embodiment may comprise another suitable mask layer. The mask layer 105 is more resistant to the plasma etch conditions than the bulk substrate material. The mask defines an opening 106 through which the substrate 103 is etched.

The substrate to be etched is positioned on the substrate support 12 in the plasma etch apparatus 10 with the face to be etched facing upwards. A pre-etch may (optionally) be performed to prepare the substrate 3 prior to the main etch cycle, for example to remove unwanted material from the open areas of the mask layer.

In a second step 109 of the method, a bulk plasma etch (i.e. a main etch) is performed to selectively etch the silicon carbide substrate so that a majority of the feature is formed. In the example embodiment, the feature is a trench (or via). The bulk plasma etch step anisotropically etches the substrate 103 through the opening 106, leaving a partially formed feature 101a. During this step, a bias power of about 1500 W is applied to the substrate support/ platen (although the bias power can vary in the range between 100 W to 1500 W). This helps to impart a directionality to the ions in the plasma so that the base of the feature is preferentially etched (rather than the sidewalls of the feature). Consequently, the width of the partially formed feature substantially corresponds to the initial width of the open area in the mask layer.

The bulk plasma etch step results in the formation of a partially formed, square-based, trench feature 101a having a flat base that is approximately perpendicular to the sidewalls of the trench. The flat base has a peripheral region 114 proximate to the sidewalls. In another embodiment, if micro-trenching has occurred, the partially formed feature may comprise a substantially convex shape.

During the bulk plasma etch 109, the chamber pressure is about 12 mTorr. Since the process conditions can be varied considerably to control the rate of deposition and therefore the profile of the base feature, in other embodiments the chamber pressure during the bulk plasma etch can be in the range of about 2 mTorr to about 60 mTorr. During the bulk plasma etch step, the plasma source power is about 2400 W (in other embodiments, it can be in the range of about 800 W to about 2500 W). Typically, the walls of the chamber are cooled by water to about 55 °C. In the example embodiment, the process gases used in the main etch step comprise each of SF₆, Cl₂, SiF₄, O₂ and Ar gas. In anther embodiment one or more of the above gases may be used. In another embodiment, He may be used for example in addition to one or more of the gases listed above. Alternative bulk etch processes could be used to form trench 101a with a flat base and a peripheral region 114.

In a third step 111 of the method, a passivation plasma etch is performed, in which the trench feature is fully formed 101b. The plasma processing parameters used during the second plasma etch step are different to those used during the first plasma etch step, as are the process gases. The passivation plasma etch step is an anisotropic plasma etch step. That is, the ions forming the plasma are generally directed towards the silicon carbide substrate 103 with a high degree of directionality. In this example embodiment, the ions forming the plasma generally bombard the substrate substantially perpendicularly to the substrate surface. Consequently, the bottom surface of high aspect ratio features can be etched without significant etching of the trench sidewalls 113.

The second plasma etch step anisotropically etches the flat bottom surface of the partially formed feature 101a. Simultaneously, a passivation layer 115 is deposited onto the sidewalls 113 of the mask 32 and also the sidewalls 113 of the feature being etched. In the example embodiment, the passivation layer 115 is silicon nitride or silicon oxynitride (SiₓN_{y} or SiₓO_{y}N_{z}). SiₓO_{y}N_{z} can be formed from active introduction of oxygen into the system or from by-products of the second plasma etch step. In the example embodiment, the passivation layer 115 and the mask are different materials but this is not necessarily the case. Without wishing to be bound by any theory or conjecture, it is believed that the thickness of the passivation layer 115 gradually increases during the passivation plasma etch step, which has the effect of gradually reducing a dimension in the opening of the mask or feature. The dimension corresponds to the minimum width (w) of the opening in the mask. This dimension can substantially correspond to a width on the bottom surface of the feature that is being etched. As the minimum width w of the opening is reduced, the etching at the peripheral region 114 of the trench is attenuated. The change in the width w translates to a reduction in the etched width at the base of the feature. Without wishing to be bound by any theory or conjecture, it is believed that the passivation material overhangs the corners of the base of the feature and consequently shields the corners of the base of the feature from the highly directional anisotropic plasma etch process. This has the effect of reducing the etch rate at the peripheral region 114 of the bottom surface (compared to a central region of the bottom surface). As a result, a feature is formed wherein the base of the feature has rounded corners and a substantially flat central region. By controlling the rate of deposition of the passivation material (and hence by controlling the dimension of the opening in the mask) and the RF power to the wafer support it is possible to control the profile at the base of the feature as desired.

Once the feature is fully formed, a further deposition-stripping step 117 is performed to remove the passivation layer 115 from the side walls 113 of the mask and feature. The removal of the passivation material can be performed using wet or dry plasma based etching. For example, a hot phosphoric acid based solution can be used as a wet etchant or a SF₆, CH₂F₂, N₂ plasma can be used to remove the passivation material while maintaining high selectivity with a SiO₂ mask.

The resultant substrate comprises a fully formed feature which has a base having a substantially flat central region and rounded or smoothed corners (or other shape as desired). A substrate which has a base or bottom surface with a smoothed profile (e.g. with rounded corners) can help to minimise field bunching. That is, the electric field is more uniformly dispersed about the feature. This can help to maximise breakdown voltages. Additionally, the present method helps to avoid the formation of micro-trenches at the corners of the feature being etched.

Importantly, the process gases used in the passivation plasma etch step 111 comprise SiCl₄ and N₂ gas. Use of the combination of a silicon containing gas and nitrogen to produce passivation during silicon carbide plasma etching, helps in the formation of rounded base trenches, whilst increasing the ease of removing the passivation layer from the chamber compared with SiO₂ based passivation. It also increases throughput due to benefits in reduced inter-wafer clean time.

Use of a silicon-containing gas (e.g. SiF₄ or SiCl₄) and nitrogen gas (e.g. N₂) produces silicon compounds containing nitrogen, namely Si_{X}N_{Y} and SiO_{X}N_{Y} (where, for example, crystalline silicon nitride has X = 3 and Y = 4, but in this case the numbers may vary). These nitrides are commonly deposited by PECVD using similar methods to that of SiO₂ but are etched by plasma much more readily with a F based plasma. That is to say unlike the SiO₂ etch process which requires ion bombardment to overcome the activation energy to break the Si-O bonds and react with an etchant species, the SiN etch process is more chemical and is driven by F concentration in the plasma and is less dependent on ion bombardment. Reduction in ion bombardment for the SiN etch step is achieved by reduced RF bias powers, in turn lower Vdc, and high pressure operation when compared to a SiO₂ etch process.

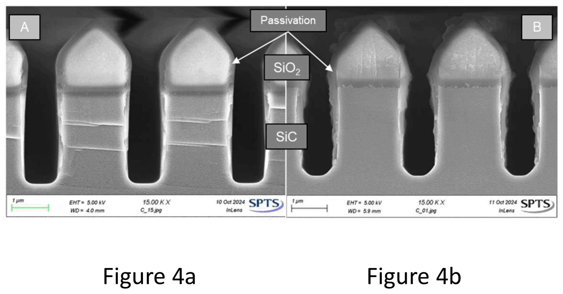

Thus according to methods of the present invention, the passivation layer etch rates for SiN and SiON can be higher than those achieved on SiO₂ which in turn minimises SiO₂ loss. It may seem likely that the same decrease in activation energy would inhibit the usefulness of the passivation to initiate rounding of the trench corners, because if the passivation is more easily etched by the plasma, then it may never form a thick layer. However, it was surprisingly found that a greater quantity of passivation material is deposited when using equal quantities of N₂ as the O₂ used in methods of the prior art (more even than expected based on the stoichiometry advantage of Si₃N₄ compared to SiO₂) as shown in Figures 4a and 4b.

Figure 4b shows a trench etched by the methodology described above, and Figure 4a shows a comparison trench formed using the exact same methodology and process parameters but using SiCl₄/O₂ instead of SiCl₄/N₂. It can be seen that there is a greater thickness of passivation material deposited in Figure 4b. In Figure 4a, the average deposition thickness at the mask to SiC interface is 130nm, and at the thickest point is 175nm. In Figure 4b, the average deposition thickness at the mask to SiC interface is 239nm, and at the thickest point is 336nm.

A smooth passivation layer is desirable, and in the example embodiment, the process parameters are optimised to produce a smooth layer.

Tuning the rounding of the base of the trench is generally achieved by modifying passivation gas flow and substrate bias together. In general passivation deposition rate increases with gas flow whereas etch rate increases as substrate bias is increased. Gas flows and substrate bias both have to be tuned together to achieve the desired degree of corner rounding. Too rapid a growth of passivation will mean a tapered corner, too little passivation may result in insufficient rounding of the corners.

In the example embodiment, the chamber pressure is reduced for the passivation etch compared to the bulk plasma etch from about 12 mTorr to about 8 mTorr. In the example embodiment, the plasma source power is reduced for the passivation etch compared to the bulk plasma etch from about 2400 W to about 1600 W. The plasma source power is ~1600 W at the beginning of the passivation etch and during the passivation plasma etch step reduces to about 1400 W.

In the example embodiment, the bias power to the substrate support is reduced slightly for the passivation etch compared to the bulk plasma etch from about 1500 W to about 1400 W. The bias power is ~1400 W at the beginning of the passivation etch and during the passivation plasma etch step reduces to about 400 W. A relatively high initial bias power is utilised compared to methods of the prior art, to increase SiC etch rate at the low initial N₂ and SiCl₄ flows and balance passivation and etch rates to achieve a smooth passivation deposition. The reduction in bias power reduces the etch rate of the SiC to help the build-up of the passivation layer.

In the example embodiment, the N₂ flow rate at the beginning of the passivation etch is about 3 sccm and during the passivation plasma etch step increases to about 40 sccm. The N₂ flow rate in the passivation etch step (i.e. of 3-40 sccm) is therefore reduced compared to the flow rate of oxygen of around 25-100 sccm in methods of the prior art. Accordingly, the SiCl₄ flow rate compensates for the reduction in flow. In the example embodiment, the SiCl₄ flow rate at the beginning of the passivation etch is about 80 sccm and during the passivation plasma etch step increases to about 160 sccm. As the N₂ flow increases with increasing SiCl₄, the growth rate of the SiN increases.

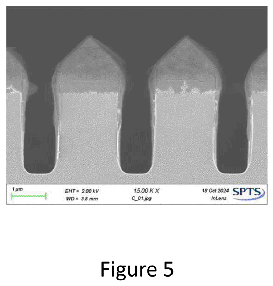

Figure 5 shows a trench which has been optimised accordingly. The result of the optimisation process is a trench with corners of a similar size and smooth shape as shown for the original O₂ version of the process (Figure 4a). In Figure 5, the average deposition thickness at the mask to SiC interface is 163nm, and at the thickest point is 203nm.

The walls of the chamber are continually cooled by water during both steps to about 55 °C.

The flow rates for the process gases in the first and second steps of the optimized process, along with various process conditions are shown in Table 1.

**Table 1**

| **Process Parameter** | **Unit** | **Step 1** | **Step 2** |
|---|---|---|---|
| Process Pressure | mTorr | 12 | 8 |
| Source Power | W | 2400 | 1600 → 1400 |
| Platen Power | W | 1500 | 1400 → 400 |
| Ar flow | sccm | 360 | 0 |
| O₂ flow | sccm | 50 | 0 |
| SF₆ flow | sccm | 25 | 0 |
| SiF₄ flow | sccm | 43 | 0 |
| Cl₂ flow | sccm | 38 | 0 |
| SiCl₄ | sccm | 0 | 80 → 160 |
| N₂ | sccm | 0 | 3 → 40 |
| Backside Helium Pressure | Torr | 10 | 10 |
| Platen Temperature | °C | 20 | 20 |

In the first step of the process, the etch rate in the above process is about 535 nm/min, and the selectivity to the SiO₂ mask is 5:1. The sidewall profile angle is about 89° and the cross-wafer depth uniformity is <3%. In the second step with N₂ used in combination with SiCl₄ improved selectivity between the passivation layer and a SiO₂ mask is achieved using a fluorine based plasma during the passivation removal step and during inter-wafer cleans when compared to a SiO₂ based passivation layer.

## Claims

1. A method of plasma etching a silicon carbide substrate to form a feature, the method comprising the steps of:
(a) Providing a silicon carbide substrate with a mask formed thereon, the mask having an opening;
(b) Performing a first plasma etch step to anisotropically etch the substrate through the opening to produce a partially formed feature having a bottom surface comprising a peripheral region;
(c) Performing a second plasma etch step to anisotropically etch the bottom surface of the partially formed feature through the opening while depositing a passivation material onto the mask so as to reduce a dimension of the opening, wherein the reduction of the dimension of the opening causes an attenuation in the etch of the peripheral region thereby producing a fully formed feature having a bottom surface comprising a central region and an edge region, wherein the central region is deeper than the edge region;
wherein, the second plasma etch step uses an etch recipe comprising a silicon-containing gas and a nitrogen or nitrogen-containing gas.

2. A method of plasma etching according to claim 1, wherein each of the silicon-containing gas and the nitrogen or nitrogen-containing gas are supplied at a flow rate to a plasma chamber containing the silicon carbide substrate, and wherein during the second plasma etch step the flow rate of the silicon-containing gas increases and the flow rate of the nitrogen or nitrogen-containing gas increases.

3. A method of plasma etching according to claim 1 or 2, wherein the silicon carbide substrate is supported on a platen within a plasma chamber, and during the second plasma etch step a source power provided to the plasma chamber reduces, and a bias power provided to the platen reduces.

4. A method of plasma etching according to claim 3, wherein the source power provided to the plasma chamber reduces between 2500-800 W, for example between 1600-1400 W.

5. A method of plasma etching according to claim 3 or 4, wherein the bias power provided to the platen reduces between 1500-100W, for example between 1400-400 W.

6. A method of plasma etching according to claim 2, wherein during the second plasma etch step the flow rate of the nitrogen or nitrogen-containing gas increases between 3-40 sccm.

7. A method of plasma etching according to claim 2 or 6, wherein during the second plasma etch step the flow rate of the silicon-containing gas increases between 80-160 sccm.

8. A method of plasma etching according to any preceding claim, wherein the silicon-containing gas is selected from SiCl₄, SiF₄ and SiF₆.

9. A method of plasma etching according to any preceding claim, wherein the silicon-containing gas is SiCl₄.

10. A method of plasma etching according to any preceding claim wherein the second plasma etch step is conducted at a process pressure between 2-60 mTorr, for example between 6-10 mTorr.

11. A method of plasma etching according to any preceding claim wherein the silicon carbide substrate is supported on a platen within a plasma chamber and wherein during both plasma etch steps, the platen is maintained at a temperature of approximately 20 degrees Celsius.

12. A method of cleaning a plasma chamber comprising performing a method of plasma etching according to any of claims 1-11, and subsequently cleaning the chamber using a fluorine-based plasma.

13. A plasma etch apparatus for plasma etching a silicon carbide substrate to form a feature using the method according to any preceding claim, the apparatus comprising:
a chamber;
a substrate support disposed within the chamber for supporting a substrate thereon;
at least one gas inlet for introducing a gas or gas mixture into the chamber at a flow rate;
a plasma generating means for sustaining a plasma in the chamber;
a power supply for supplying a bias power to the substrate support;
a controller configured to switch from a first set of processing conditions to a second set of processing conditions, wherein the first set of processing conditions cause the plasma etch apparatus to perform a first plasma etch step to anisotropically etch the substrate through the opening to produce a partially formed feature having a bottom surface comprising a peripheral region, and wherein the second set of processing conditions cause the plasma etch apparatus to perform a second plasma etch step to anisotropically etch the bottom surface of the partially formed feature through the opening while depositing a passivation material onto the mask so as to reduce a dimension of the opening, wherein the reduction of the dimension of the opening causes an attenuation in the etch of the peripheral region thereby producing a fully formed feature having a bottom surface comprising a central region and an edge region, wherein the central region is deeper than the edge region;
wherein, the second plasma etch step uses an etch recipe comprising a silicon-containing gas and a nitrogen or nitrogen-containing gas.
